Europäisches Patentamt

European Patent Office

Office européen des brevets

(11) Publication number: 0 249 252
A1

# EUROPEAN PATENT APPLICATION

(21) Application number: 87200117.7

(22) Date of filing: 09.07.84

(51) Int. Cl.⁴: **H01B 3/10 , H01B 7/34 , H01B 13/06**

(30) Priority: 08.07.83 GB 8318612

(43) Date of publication of application:
16.12.87 Bulletin 87/51

(60) Publication number of the earlier application in accordance with Art.76 EPC: 0 132 343

(84) Designated Contracting States:
AT BE CH DE FR IT LI NL SE

(71) Applicant: RAYCHEM LIMITED
Rolls House 7, Rolls Buildings Fetter Lane
London, EC4 1NL(GB)

(72) Inventor: O'Brien, James Martin
1 Osprey Close
Swindon Wiltshire(GB)
Inventor: Penneck, Richard John
Treeve Westway
Lechlade Gloucestershire(GB)
Inventor: Duckworth, Stephen John
5 Austen Crescent Liden
Swindon Wiltshire(GB)

(74) Representative: Dlugosz, Anthony Charles et al
Raychem Limited Intellectual Property Law
Department Swan House 37-39 High Holborn
London WC1(GB)

(54) Wire and cable.

(57) A metallic conductor for an electrical wire or cable comprises a bundle of metallic strands 1 and is provided with an adherent electrically insulating refractory coating 2. The coating extends around the circumference of the bundle but not around the individual strands. The coating may be applied by a vacuum deposition process such as a sputter ion plating method. Adhesion of the coating may be improved by the provision of a metallic or refractory intermediate layer and/or by varying the stoichiometry of the coating through its thickness.

Wires using the conductors are particularly suitable for use in circuit and signal integrity cables.

EP 0 249 252 A1

## WIRE AND CABLE

This invention relates to electrical wire and cables and to electrical conductors suitable for use therein.

Numerous forms of electrical cable have been proposed for use in environments where there is a risk of fire and accordingly where fire retardency of the cable is required. These cables may make use of specific, highly effective, halogenated polymers or flame retardant materials such as polytetrafluoraethylene, polyvinyl chloride, or polyvinylidine fluoride as polymers or decarbromodiphenyl ether as flame retardant additives. Halogenated systems, however, suffer from the disadvantage that when they are heated to high temperatures during a fire, they liberate toxic and corrosive gases such as hydrogen halides, and a number of halogen free insulating compositions have therefore been proposed, for example in U.S. patent specification No. 4,322,575 to Skipper and in U.K. patent specification Nos. 1,603,205 and 2,068,347A, the disclosures of which are incorporated herein by reference.

In certain fields where cables are used, for example in military, marine or mass transit applications, it is desired to use cables which are capable of functioning at relatively high temperatures. In other instances it is desired to use cables which not only do not burn, or, if they burn, do not liberate toxic or corrosive gases, but also are capable of functioning after having been subjected to a fire, or preferably for a period of time during a fire without shorting or otherwise failing. Cables that are capable of functioning for a period of time during a fire have been called circuit integrity cables or signal integrity cables depending on their use. The previously proposed circuit and signal integrity cables have generally used the principle that the individual conductors should be separated from one another by mica tapes or by large volumes of packing materials or silicones or by combinations thereof in order to prevent the formation of short circuits during a fire, with the result that the previously proposed cables are relatively heavy or large or both. There is therefore a need for a cable that will function at relatively high temperatures or will function after it has been subjected to a fire, and which preferably will retain its integrity for a period of time during a fire but which is smaller or lighter than the previously proposed cables.

According to one aspect, the present invention provides an electrical wire which comprises an elongate metallic electrical conductor having an adherent electrically insulating refractory coating formed from a compound of a metal or semi-metal other than that from which the conductor is formed, e.g. an oxide or nitride, the refractory coating having been formed on the conductor by a vacuum deposition method, and, surrounding the coated conductor, a layer of polymeric insulation.

Preferably the refractory coating is bonded to the conductor by a metallic or refractory intermediate layer, and so according to another aspect, the invention provides an electrical wire which comprises an elongate metallic electrical conductor having an adherent refractory coating which is bonded to the conductor by a metallic or refractory intermediate layer, and which has preferably been formed by a vacuum deposition method, and, surrounding the coated conductor, a layer of polymeric insulation.

Preferably the metal forming the conductor has a melting point of at least 800°C more preferably at least 900°C, and especially at least 1000°C, the most preferred metal being copper although in some instances it is possible for the conductor to have a melting point below 800°C, for example it is possible for the conductor to be formed from aluminium if the required temperature rating of the wire is not particularly high. The conductor may be a solid conductor or it may be a stranded conductor in which individual strands are laid together to form a bundle which preferably contains 7, 19 or 37 strands. Where the conductor is stranded it is preferred for the bundle to be coated rather than the individual strands, that is to say, the refractory coating extends around the circumference of the bundle but not around the individual strands so that substantially only the outwardly lying surfaces of the outermost layer of strands are coated. Thus, according to another aspect, the invention provides a metallic conductor which comprises a bundle of metallic strands the bundle having an adherent coating of an electrically insulating refractory oxide or nitride of a metal or semi-metal which extends around the circumference of the bundle but not around the individual strands. This form of conductor has the advantage that the inter strand electrical contact is retained and the dimensions of the bundle are kept to a minimum (since the thickness of the coating may constitute a significant proportion of the strand dimensions for fine gauge conductors) and also it aids the formation of good electrical connections, e.g. crimp connections, to the conductor because a large proportion of the surface of the strands, and the entire surface of the strands in the central region of the conductor, will be uncoated.

The wire according to the invention, at least in its preferred aspects described below, is particularly suitable for forming signal integrity cables and circuit integrity cables because, depending on the construction of the wire, when a portion of the cable is subjected to a fire, the refractory coating will provide sufficient insulation between the conductors to enable the cable to operate for a significant length of time even when all the polymeric insulation has been lost. The length of time for which the wire will still operate will clearly depend on the temperature to which it is subjected, and, in fact, in view of the refractory nature of the insulating coating, the temperatures at which some of the wires and cable according to the invention can operate at least for short periods of time is limited only by the nature of the metal forming the conductor.

An additional advantage of the wire and cable according to the invention is that it is very flexible as compared with other signal and circuit integrity cables, especially if a stranded conductor is used. The ability of the wire to be bent around very tight bends (small bend radii) without deleterious effect is partly due to the fact that the layer providing the integrity is thinner than with other signal and circuit integrity cables. However, when the conductor is a standed conductor it may be bent around extremely tight bends without undue stress of the surface of the stands because the strands are displaced from a regular hexagonal packing at the apex of the bend thereby exposing uncoated areas of the strands to the eye. It is highly surprising that even though uncoated strands may be exposed when the wire conductor is bent there is no electrical contact between adjacent stranded conductors after the polymeric insulation has been removed. It is believed that in this case the integrity is retained because the profile of a stranded conductor is not cylindrical but rather as in the form of a hexagon that rotates along the length of the conductors, so that adjacent stranded conductors will touch one another only at a few points along their length, which points are always provided by the outwardly oriented part of the surface of the strands in the outer layer of the conductors. It is these points of contact that are always provided with the refractory coating.

The refractory coating preferably has a thickness of at least 0.5, more preferably at least 1 and especially at least 2 micrometres but preferably not more than 15 and especially not more than 10 micrometres, the most preferred thickness being about 5 micrometres depending upon specific operational requirements. The exact thickness desired will depend on a number of factors including the type of layer and the voltage rating of the wire, circuit integrity cables usually requiring a somewhat thicker coating than signal integrity cables and sometimes above 15 micrometres. The lower limits for the coating thickness are usually determined by the required voltage rating of the wire whilst the upper limits are usually determined by the time, and there fore the cost, of the coating operation.

Preferably the insulating refractory coating is formed from an electrically insulating infusible or refractory metal or semi-metal oxide or nitride and the invention will be described below in many cases with respect to oxides and nitrides although othe refractory coatings are included. By the term "infusible" or "refractory" is meant that the coating material in its bulk form should not fuse or decompose when subjected to a temperature of 800°C, for 3 hours. Preferably the oxide or nitride should be able to withstand higher temperatures also, for example it should be able to withstand a temperature of 1000°C for at least 20 to 30 minutes. The preferred oxides and nitrides are those of aluminium, titanium, tantalum and silicon or mixtures thereof with themselves or with other oxides or nitrides. Thus, for example, the use of mixed metal oxides for the refractory coating are also encompassed by the present invention. It should be appreciated that the oxide or nitride layer need not, and in many cases will not, have a precisely defined stoichiometry. In a number of cases, depending on the method of forming the refractory coating, the coating will contain the metal or semi-metal in a stoichiometric excess, that is to say, the coating will contain more metal than is required for the stoichiometry of a defined formal oxidation state of the metal. Accordingly the terms "alimunium oxide", "titanium oxide", "tantalum oxide", "metal oxide" and the equvalent terms when referring to nitrides are intended to include non-stoichiometric compounds. It is often advantageous for the refractory coating to be non-stoichiometric since this may increase the adhesion between the refractory coating and the conductor or any underlying layer, and especially if the stoichiometry of the refractory coating varies through at least part of its thickness so that stresses that may be induced in the coating, for example due to differential thermal expansion, are not localised to a boundry of the coating and so that different parts of the coating will exhibit different properties. For example, a relatively metal-rich part of the coating may exhibit good adhesion to the conductor or intermediate layer while parts of the coating having least metal or semi-metal may exhibit the best electrical properties.

Thus, according to another aspect, the invention provides an elongate metallic electrical conductor having an adherent coating of a refractory oxide or nitride of a metal or semi-metal, the coating having a stoichiometry that varies through at least part of its thickness such that the proportion of oxygen or nitrogen increases toward the outer surface of the coating. If desired, the stoichiometry of the refractory coating may vary continuously throughout the thickness of the coating or it may contain one or more layers or strata of relatively uniform stoichiometry. Thus the coating may have an outer region of relatively uniform stoichiometry and preferably of a relatively high oxygen or nitrogen content in order to exhibit the optimum electrical properties. The relative thicknesses of the non-uniform and uniform layers may vary widely. For example the major part of the coating may have a non-uniform stoichiometry or the major part of the coating's thickness may be of uniform stoichiometry, in which latter case the non-uniform part of the coating could even be considered as an intermediate layer that improves adhesion of the coating especially at high temperatures. If the underlying metal or semi-metal-rich part of the coating is intended to improve the adhesion of the refractory coating, its particular composition will depend on the composition of any underlying layer, and in some cases it may be desirable for the metal or semi-metal rich part to consist substantially entirely of the metal or semi-metal so that there is a gradual change from the metal or semi-metal to the oxide or nitride. This is particularly preferred if the system includes an intermediate layer of the same metal or semi-metal.

The precise stoichiometry of the uniform top layer can be determined experimentally using wavelength dispersive electron microprobe analysis or by using x-ray photoelectron spectroscopy (XPS). The composition of the coating as it changes from metal to refractory throughout its depth can be assessed using Auger electron spectroscopy (AES) in which the film is continuously sputtered away to expose fresh surface for composition analysis.

The variation in stoichiometry is not limited to a variation in the metal or semi-metal/oxygen or nitrogen proportions. In addition or alternatively the relative proportions of two different metals or semi-metals may be varied so that, for example, there is a gradual change from one metal, which may constitute an intermediate layer, to the oxide or nitride of a different metal.

The outer region of the refractory coating preferably has a molar oxygen or nitrogen content that is at least 50%, more preferably at least 65% and especially at least 80% of the oxygen or nitrogen content of a defined stable formal oxidation state of the metal. Thus the preferred oxide composition of the outer region may be represented as

$MO_x$ where x is at least 0.75, preferably at least 1 and especially at least 1.25 in the case of aluminium, at least 1, preferably at least 1.3 and especially at least 1.5 in the case of titanium or silicon, and at least 1.25, preferably at least 1.6 and especially at least 2 in the case of tantalum.

For relatively thin refractory coatings that have a stoichiometric excess of the metal or semi-metal it has been found that the coating remains insulating as the temperature is raised up to a certain temperature, usually in the range of 300 to 600 °C and then becomes conductive when a load of 30 V is applied. In general the electrical properties of the coatings, as determined by the temperature of onset of conductivity, may be improved both by increasing the thickness of the coating and by increas ing the oxygen or nitrogen content thereof although to some extent either the thickness or the oxygen or nitrogen content may be increased at the expense of the other.

Although it is possible, at least in the broadest aspect of the invention, for the refractory coating to consist of a single layer only which is desposited on the conductor, it is possible, and in many cases preferable, for one or more additional layers to be formed. For example a refractory coating comprising an oxide may have a refractory nitride layer thereon. Examples of nitrides that may be deposited on refractory coatings to improve the mechanical properties include titanium nitride or aluminium nitride.

Other examples of additional layers that may be exployed are metallic or refractory intermediate layers located between the conductor and the refractory oxide or nitride coating as mentioned above. Metallic intermediate layers may be present in order to improve the adhesion between the refractory coating and the conductor and include those metals from which the refractory coating is formed or other metals or both. Preferred metallic intermediate layers include those formed from aluminium, titanium, tantalum or silicon although other metals, e.g. nickel, silver or tin may be used, which may have been previously applied to the conductor by conventional techniques. Thus, for example, while copper is the preferred metal for forming the conductor, a silver plated steel wire may be used if the wire is intended to carry very high frequency signals. By examination of wire samples using a scanning electron microscope, it has been observed that two failure mechanisms of coated conduc-

be used, which may have been previously applied to the conductor by conventional techniques. Thus, for example, while copper is the preferred metal for forming the conductor, a silver plated steel wire may be used if the wire is intended to carry very high frequency signals. By examination of wire samples using a scanning electron microscope, it has been observed that two failure mechanisms of coated conductors that are exposed either to very high temperatures (about 900°C) or even to relatively low temperatures (500°C) for long periods of time, may be eliminated or substantially reduced by provision of a metallic intermediate layer, especially in conjunction with a refractory coating that has a region of non-uniform stoichiometry. The first failure mechanism is spalling of the refractory coating wherein the coating cracks and then falls off the conductor in flakes. The second failure mechanism, referred to hereafter as "conductor migration" or "copper migration" is one in which small holes or cracks occur in the refractory coating and the underlying conductor metal, usually copper, exudes through the holes or cracks to form microscopic masses of conductor metal on the outer surface of the coating. The masses may be in the form of small globules or a network of "dyked" formed in the cracks or in extreme cases they may even coalesce to form a layer on top of the refractory coating. Surprisingly, with a Copper conductor, this failure mechanism may occur at temperatures as low as 500°C, well below the conductor melting point. It is believed that provision of an intermediate layer and/or varying the stoichiometry of the refractory coating reduces the interfacial stress and hence crack formation in the coating, and thereby prevents or reduces conductor migration since this occurs most easily through cracks.

This failure mechanism, and the solution to the failure mechanism is applicable to a wide range of articles in which refractory coatings are provided for thermal protection, mechanical protection, corrosion protection and the like. Examples of such articles include electrical connectors, mechanical couplings casings and the like. Accordingly, yet another aspect of the invention provides:

An article of manufacture that is formed at least partly from a metal and has, on at least part of a metallic surface thereof, an adherent refractory coating for protecting the article, wherein the refractory coating has a stoichiometry that varies such that the proportion of metal in the refractory coating increases toward the surface of the underlying metallic article and/or the coating is bonded to the article by means of an intermediate metallic or refractory layer, so that migration of underlying metal of the article through the refractory coating when the article is heated is suppressed.

All the compositions, structures and processes described herein are applicable to such articles.

More than one intermediate layer may be provided on the conductor if desired, for instance a barrier layer may be provided between the conductor and the other intermediate layer or an alloy layer may be formed from a deposited metal and the conductor metal (e.g. Aluminium/copper) during manufacture, or in a subsequent heating step or in high temperature use. In at least some cases the provision of an alloy layer significantly improves adhesion of the coating.

In the case of wires according to the invention, the polymeric insulation is provided in order to provide additional insulation to the conductor during normal service conditions and also to enable the wire to have the desired dielectric properties. However, an important advantage of the present invention is that since a significant proportion of the service insulating properties are provided by the refractory coating, the electrical properties of the polymeric insulation are not as critical as with other wire constructions in which the polymeric insulation provides the sole insulation between the conductors. Of the known polymeric materials that are used for electrical insulation, polyethylene probably has the most suitable electrical properties but is highly flammable, and has poor mechanical properties. Attempts to flame retard polyethylene have either required halogenated flame retardants which, by their nature, liberate corrosive and toxic hydrogen halides when subjected to fire, or have required relatively large quantities of halogen free flame retardants which have a deleterious effect on the electrical properties and often also the mechanical properties of the polymer. Accordingly, an acceptable wire has in the past only been achieved by a compromise between different properties which is often resolved by using a relatively thick-walled polymeric insulation and/or dual wall constructions. Although such forms of polymeric insulation may be used with the wire according to the present invention, the presence of the refractory layer does obviate these problems to a large extent since the polymer used for the insulation may be chosen or its flammability and/or its mechanical properties at the expense of its electrical properties. As examples of polymers that may be used to form the polymeric insulation there may be mentioned polyolefins e.g. ethylene homopolymers and copolymers with alpha olefins, halogenated polymers e.g. tetrafluoroethylene, vinylidene fluoride, hexafluoropropylene and vinyl chloride homo or copolymers polyamides, polyesters, polyimides, polyether ketones e.g. polyarylether ketones, aromatic polyether imides and sulphones, silicones, alkene/vinyl acetate copolymers and the like. The polymers may be used alone or as blends with one another and may contain fillers e.g. silica and metal oxides e.g. treated and untreated metal oxide flame retardants such as hydrated alumina and titania. The polymers may be used in single wall constructions or in multiple wall constructions, for example a polyvinylidine fluoride layer may be located on for example a polyethylene layer. The polymers may be uncrosslinked but preferably are crosslinked, for example by chemical cross-linking agents or by electron or gamma irradiation, in order to improve their mechanical properties and to reduce flowing when heated. They may also contain other materials e.g. antioxidants, stabilizers, crosslinking promotors, processing aids and the like. It is more particulalry preferred for the polymeric insulation to contain a filler e.g. hydrated alumina, hydrated titania, dawsonite, silica and the like, and especially a filler that has the same chemical composition, at least under pyrolysis conditions, as the refractory coating, so that the filler in the polymeric insulation will provide additional insulation when the wire or cable is subjected to a fire. Another preferred type of polymeric insulation is that based on an aromatic polymer, for instance certain aromatic polymers mentioned above, that will char or ash when subjected to a fire so that the char or ash, together with the refractory coating, will provide the necessary insulation during a fire. Examples of polymers, compositions, their manufacture and wires using them are described in U.S. Patent Specifications Nos. 3,269,862, 3,580,829, 3,953,400, 3,956,240, 4,155,823, 4,121,001 and 4,320, 224, British Patent Specifications Nos. 1,473,972, 1,603,205, 2,068,347 and 2,035,333, 1,604,405 and in European Patent Specification No. 69,598, the disclosures of which are incorporated herein by reference. Preferably the wire is substantially halogen free.

At least for certain aspects of the present invention, the oxide layer may be applied to the conductor by any of a number of techniques. For example a metal layer may be deposited and then oxidized, e.g. an aluminium layer may be formed and then anodized. Alternatively the metal may be oxidised in a commercially available plasma oxidation unit. The formation of the metal layer may be achieved in a number of ways, for instance by electroplating, standard wire cladding techniques such as roll bonding, and by vacuum deposition techniques e.g. sputtering, evaporation, flame spraying, plasma assisted chemical vapour deposition (CVD) or other techniques. Alternatively the coating may be formed by a plasma ashing technique in which the metallic conductor is coated with, for example, a titanate or siloxane resin and is then passed through an oxygen glow discharge plasma whereupon the resin is "ashed" to leave a coating of titanium dioxide or silica on the conductor.

The oxide coating may also be applied directly to the substrate which may be the uncoated conductor or conductor coated with one or more intermediate layers. A vacuum deposition method such as evaporation, plasma assisted chemical vapour deposition, or especially a sputtering method is preferred.

In the sputtering method, predominantly neutral atomic or molecular species are ejected from a target, which may be formed from the material to be deposited, under the bombardment of inert positive ions e.g. argon ions. The high energy species ejected will travel considerable distances to be deposited on the wire conductor substrate held in a medium vacuum, e.g. $10^{-4}$ to $10^{-2}$ mbar. The positive ions required for bombardment may be generated in a glow discharge where the sputtering target serves as the cathode electrode to the glow discharge system. The negative potential (with respect to ground and the glow discharge is maintained in the case of insulating target materials by the use of radio frequency power applied to the cathode, which maintains the target surface at a negative potential throughout the process. DC power may be applied when the target is an electrically conducting material. The advantage of such techniques is that control of the target material is greatly enhanced, and the energy of the species ejected is very much higher than with evaporation methods e.g. typically 1 to 10 eV for sputtering as compared with 0.1 to 0.5 eV for evaporation methods. Considerable improvements in interfacial bonding are achieved but the deposition rate in the sputtering process described will be lower than that for electron beam evaporation.

In magnetron sputtering processes the plasma is concentrated immediately in front of the cathode (target) by means of a magnetic field. The effect of the magnetic field on the gas discharge is dramatic. In that area of discharge where permanent magnets, usually installed behind the cathode, create a sufficiently strong magnetic field vertically to the electric field, secondary electrons resulting from the sputter bombardment process will be deflected by means of the Lorenz force into circular or helical paths. Thus the density of electrons immediately in front of the cathode as well as the number of ionised argon atoms bombarding the cathode are substantially increased. The result of this increase in plasma density is a considerable increase in deposition rate. Bias sputtering (or sputter ion plating) may be employed as a variation of this technique. In this case the wire conductor is held at a negative potential relative to the chamber and plasma. The bombardment of the wire conductor by Argon ions results in highly cleaned surfaces. Sputtering of the target material onto the wire conductor throughout this process results in a simultaneous deposition/cleaning mechanism. This has the advantage that the interfacial bonding is considerably improved. In sputter ion plating systems both substrate and the wire conductor are held at a negative potential. In this case the relative potentials are balanced to promote preferential sputtering of the target material. The target voltage will be typically less than 1KV, dependant on system design and target material. The wire substrate, may be immersed in its own localised plasma dependant upon its bias potential, which will be lower than that of the target. The exact voltage/power relationship achieved at either target or substrate is dependant upon many variables and will differ in detail from system to system. Typical power densities on the target are 10-20w/cm². The load to the substrate may be substantially lower, often as little as 5% of the target load.

The preferred technique that is used to apply the oxide or nitride coating is a reactive bias sputtering method in which reactive gas is introduced into the vacuum chamber in addition to argon so that the oxide/nitride of the target material, which in this case is a metal rather than the oxide/nitride will be deposited. Experimental results have shown that the level of reactive gas and its admission rate have a significant effect on deposition rates. The precision control of partial pressure of the reactive gas and the analysis of the sputtering atmosphere in a closed loop control system is considered highly desirable. Apart from the simultaneous deposition/cleaning advantages mentioned above, the ion bombardment of the substrate provided by the r.f. discharges enhances surface reaction between the reactive gas and depositing species, resulting in more efficient formation of the coating with the required stoichiometry.

Partial pressure of reactive gas is determined experimentally but will normally be between 2 and 25% but sometimes up to 30%, the exact level depending on the required stoichiometry of the coating and deposition rate. Reactive sputtering is also the preferred technique because it facilitates alterations to the stoichiometry of the coating. For example, an intermediate "layer" of the pure metal used for the oxide/nitride coating may be deposited in such a way that there is no defined boundary between the conductor metal, oxide/nitride metal and oxide/nitride layers.

The vacuum chambers and ancillary equipment, including micro-processor gas control units and a variety of targets used in these mathods may be purchased commercially. Many variations in design are possible but most employ the use of "box" shaped chambers which can be pumped down to high vacuum for use in any of the vacuum deposition processes mentioned. Systems are normally, but not exclusively, dedicated to one deposition process. One system which may be employed to coat wires uses air to air transfer techniques for passage of the wire conductor through the deposition chambers and empoys one or more ancilliary vauum chambers either side of the main deposition chamber.

These ancilliary chambers are held at progressively higher pressures as they extend from deposition chamber to air. This reduces the load on individual vacuum seals. The system described has the advantage of continuous feed of the wire conductor over batch process arrangements. In the vacuum deposition chamber the pressure is held constant at a pressure normally between $10^{-4}$ and $10^{-2}$ Torr.

The targets employed are commercially available Planar Magetron Sputtering sources. Their size may vary widely, and targets in excess of 2 metres in length may be employed. Between two and four such sources may be arranged opposite one another so as to surround the wire conductor passing through the chamber or to sputter from at least two sides. The arrangement may be employed in series to increase wire throughput rates. As described above a negative bias is applied to the magnetron to initiate the sputtering process. The wire may be held at a lower negative bias as described earlier.

Refinements to the system can, if desired, be employed. For example, the use of an intermediate vacuum station between the air (input side) and the deposition chamber may be employed to generate an Argon ion glow discharge which cleans the wire conductor suface by ion bombardment prior to its entry into the vacuum deposition chamber and also heats the wire conductor.

Further intermediate chambers can be employed between the cleaning and deposition chamber to deposit intermediate layers which may be used to increase bonding or oxide /nitride to wire compatibility. Conditions may be controlled to produce any of the conductor coatings described above in which no defined boundries occur between the layers. For example an intermediate "layer" of the pure metal used for the refractory coating may be deposited in such a way that there is no defined boundry between the conductor metal, the intermediate layer and the oxide or nitride coating. In a similar fashion additional chambers can be employed between the deposition chamber and air (output end) to deposit different metal, metal oxide or metal alloys onto the refractory coating for improved lubrication or wear resistance.

Evaporation and the related processes of activated evaporation and ion plating offer alternative techniques for deposition of the coating, with significant advantages in deposition rate.

Evaporation of the coating material is achieved by heating the material such that its vapour pressure exceeds $10^{-2}$mbar. Evaporation temperatures vary according to coating material, e.g. 1300-1800°C for refractory metal oxides, the pressure being usually $10^{-4}$ to $10^{-6}$mbar. Similar wire transport system to those described may be used to hold the substrate about 30-40 cm above the source. Several heating methods exist e.g. resistive, inductive, electron beam impingement etc. although the preferred method is an electron beam source where a beam of high voltage electrons e.g. at a potential of 10,000V impinge onto the coating material contained in a water-cooled crucible. The use of multi-pot crucibles or twin source guns, enable multiple layers and graded stoichiometry layers to be deposited with the aid of electronic monitoring and control equipment.

Compound coatings can be made either by direct evaporation from that compound e.g. $Al_2O_3$ or by reactive evaporation, e.g. aluminium evaporated into a partial pressure of oxygen to give aluminium oxide. Variations in the process exist either to promote reactions or adhesion, e.g. Activated reactive evaporation (ARE) can be used to increase the reaction probably between the evaporant and the reactive gas.

In ion-plating, negative bias applied to the substrate in an inert gas, promotes simultaneous cleaning/deposition mechanisms for optimising adhesion as described in the sputtering process. Bias level of -2KV are typically used but these can be reduced to suit wire substrates. Alternatively, high bias can be applied to a plate positioned behind the traverse wire to achieve a similar effect. As operation pressures are higher in the ion plating technique, e.g. $10^{-3}$ to $10^{-2}$mbar, gas scattering results in a more even coating distribution. To protect the filament the electron beam gun in the ion plating technique is differentially pumped to maintain vacuum higher than $10^{-4}$ mbar.

In the Plasma assisted chemical vapour deposition (PACVD) method the substrate to be coated is immersed in a low pressure (0.1 to 10 Torr) plasma of the appropriate gases/volatile compounds. This pressure is maintained by balancing the total gas flow-rate (1 to 1000 cm³/min) against the throughput of the pumping system. The plasma is electrically activated and sustained by coupling the energy from a power generator through a matching network into the gas medium. Thin films have been successfully deposited from direct current and higher frequency plasmas well into the microwave range. At high frequencies the energy may be capacitatively or inductively coupled depending on chanber design and electrode configuration. Typically a 13.56 MHz radio-frequency generator would be used having a rating which would allow a power density of between 0.1 - 10W/cm² in a capacitatively-coupled parallel-plate type reactor. The substrate, which could be set at a temperature of up to 400°C, may be grounded, floating at plasma potential or subjected to a dc voltage bias as required. Typically deposition rates for this technique can be favourably compared with those obtained by sputtering. The deposition of alumina may be achieved by immersing a substrate in a plasma containing a volatile alumina compound (e.g. Tri-methyl aluminium or Aluminium butoxide) and oxygen under appropriate processing conditions.

After the oxide coating has been deposited on the wire conductor the polymeric insulation may be extruded onto the coated conductor by methods well known in the art.

In order to form a circuit or signal integrity on cable the appropriate wires according to the invention may simply be laid together and be enclosed in a jacket. If desired the wires may be provided with a screen or electromagnetic interference shield before the cable jacket is applied. Thus a cable may be formed in a continuous process by means well known in the art by braiding the wire bundle and extruding a cable jacket thereon. Any of the materials described above for the wire polymeric insulation may be used although halogen-free compositions e.g. compositions as described in the U.K. Patent Specifications Nos. 1,603,205 and 2,068,347A mentioned above are preferred. It is of courde possible to employ additional means for providing integrity of the cable such as mica tape wraps, but these are not necessary nor are they desirable in view of the increased size and weight of the cable.

In certain circumstances it may be desirable to coat the oxide layer with a thin coating of a polymeric resin or lacquer in order to provide a barrier against water or electrolytes during service.

The present invention is especially suitable for forming flat cables which, as will be appreciated, are not susceptible to being wrapped with mica tape. Thus according to another aspect of the invention there is provided a flat cable which comprises a plurality of elongate metallic electrical conductors which have an adherent coating of an electrically insulating refractory oxide or nitride of a metal or semi-metal other than that from which the conductors are formed, the conductors being laid in side-by-side relationship and enclosed in a continuous polymeric cable insulating layer.

Several embodiments of the invention and a method of production thereof will now be described by way of example with reference to the accompanying drawings in which:

Figure 1 is a cross-section through one form of wire according to the present invention;

Figure 2 is a cross-section through a signal integrity cable employing the wires of figure 1;

Figure 3 is a cross-section through part of a flat conductor flat cable;

Figure 4 is a schematic view of part of the sputtering apparatus showing its wire handling mechanism; and

Figure 5 is a graphical representation showing the variation in composition of the coating against thickness.

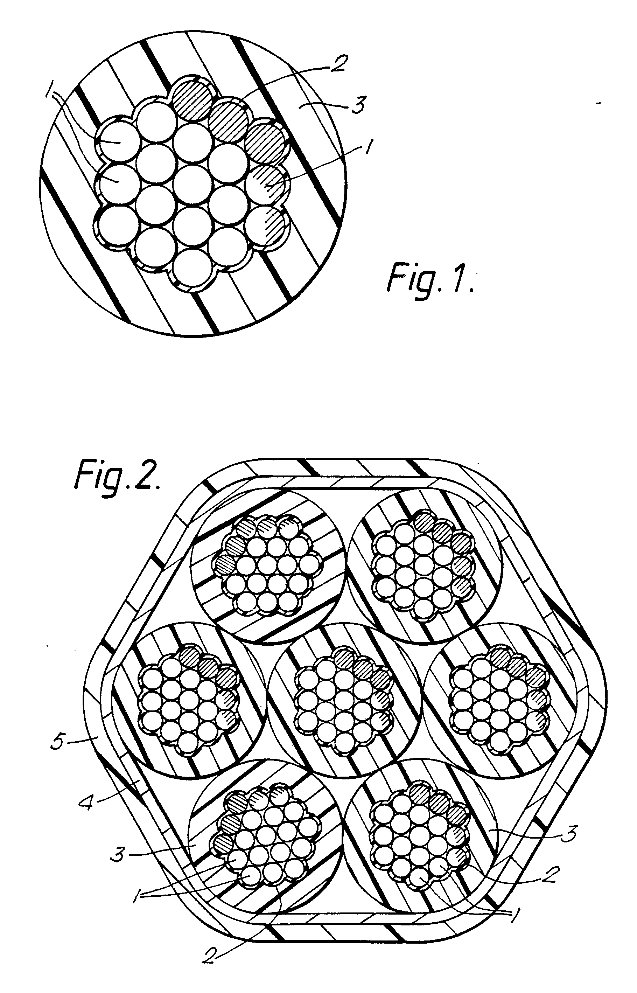

Referring to figure 1 of the drawings a 26 AWG stranded copper conductor formed from 19 copper strands 1 is coated with a 5 micrometre thick layer 2 of aluminium oxide by the reactive sputter ion plating method described above. A coating 3 based on a polyetherimide sold under the trade mane "ULTEM" is then extruded on the oxide coated conductor to form a polymeric "insulating" layer of mean wall thickness 0.2 mm.

Figure 2 shows a signal integrity cable formed by laying together seven wires shown in figure 1, forming an electromagnetic interference screen 4 about the bundle by braiding and then extruding thereon a jacket 5 based on a halogen-free composition as described in British Patent Specification No. 2,068,347 Example 1A.

The cable so formed is particularly lightweight and has a relatively small overall diameter in relation to the volume of the copper conductor.

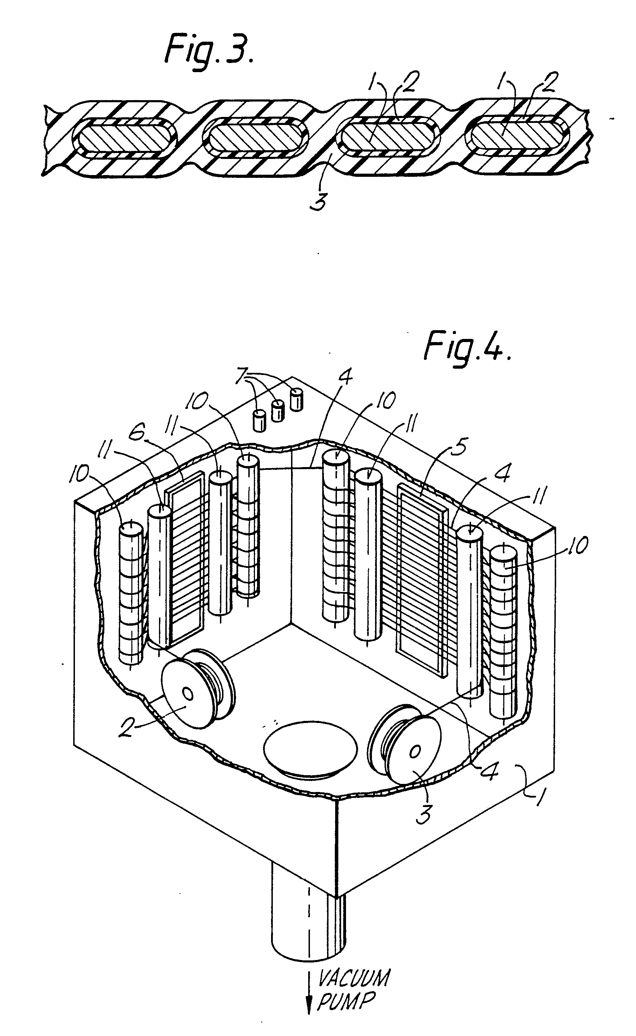

Figure 3 shows a flat conductor flat cable comprising an array of flat copper conductors 1 with a 100 mil (2.54 mm) spacing. Each copper conductor 1 is provided with a 5 micrometre alumina coating as described above and the coated conductors are embedded in a single polymeric insulating layer formed from the polyether imide sold under the trade name "ULTEM".

Apparatus for use in a batch process for coating wire conductor substrate is illustrated in Fig. 4. The apparatus comprises a vacuum chamber into which a complete wire transport mechanism which includes wire pay-off reel 2 and take-up reel 3, wire support rolls 10 and tensioning rolls 11 is loaded. The mechanism engages motor drives which control the passage of wire 4 so that the wire traverses a vertically mounted target 5 a number of times. Deposition occurs by the processes previously described. As before, variations in set-up are possible. An additional target (not shown) may be employed on the other side of the wire to increase coating rates and additional targets, e.g. target 6 can be employed to deposit intermediate layers before and/or after deposition of the primary oxide/ nitride coating. Suitable design of the gas inlet system to suit the specific geometries employed can facilitate deposition of layers which have no defined boundaries as described previously. Batch length will depend on chamber dimensions and transport system design.

In the operation of such a batch process wire 4 is transferred from one reel 2 to the other 3 within the chamber. The route taken by the wire may cause it to pass before the smaller ancillary target 6 to deposit an intermediate layer of any desired material. Power to this target, combined with wire speed and the number of passes in front of the target will control the thickness of the intermediate layer deposit. The wire 4 may then pass in front of the larger primary target 5 to deposit the main coating. Again thickness will be dictated by a combination of power, wire speed and a number of passes. The ratio of thicknesses between the intermediate and the primary coating is controlled in the same way. Multi-layers can be built up by reversing the mechanism as desired such that the wire 4 passes back past the targets 5,6 in reverse order. Thickness and compositions may be altered in the reverse pass as required, e.g. the process employed at the smaller magnetron may be reactive on the reverse pass to deposit a compound of the metal on the intermediate layer, e.g. Ti and $TiN_x$. Deposition of layers with no defined boundary between the metal intermediate layers (or substrates) and the oxide/nitride coatings may be achieved by setting up gradients of reactive gas in front of the primary target, such that wire at the top edge of the target 5 is subjected to deposition in an Argon rich atmosphere which gradually increases in reactive gas contant as the wire progresses down the face of the target. A gradient can be achieved by a baffle system (not shown) which progressively leaks oxygen introduced at the bottom end of the target towards the upper end.

A simpler technique for producing the layer with no defined boundary involves use of a multipass process in which wire 4 is passed back and forth through the system, and with each pass the level of reactive gas is increased to a final level required to obtain the correct stoichiometry. Thus the stoichiometry of the intermediate layer increases in a series of small incremental steps from metal to required stoichiometry. Composite targets may also be used to produce intermediate layers with stoichiometry gradients. In the case of discrete articles, the articles may instead be held in front of the target by means of a rotating sample holder.

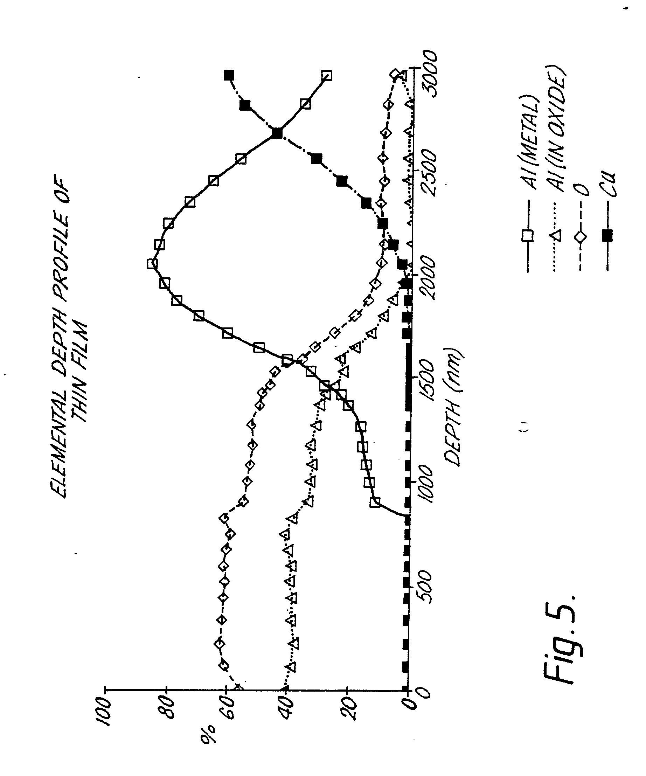

Figure 5 is an Auger electron spectrogram for a coating having a 1 micrometre top layer of alumina, an intermediate region that varies in stoichiometry for about 0.7 micrometres to a metal intermediate layer of aluminium also measuring 0.7 micrometres. The film is deposited on a copper conductor.

The following Examples illustrate the invention:

EXAMPLES 1 and 2

Copper conductors were provided with an insulating aluminium oxide coating, approximately 2 micrometres thick, by use of the sputtering apparatus shown schematically in figure 4 of the drawings. The sputtering conditions were as follows: The wire 4 was precleaned by vapour degreasing in 1,1-trichloroethane prior to the deposition. The cleaning was achieved by passing wire continuously through the vapour in a vapour degreasing bath such that a residence time of 3 minutes was achieved. The wire 4 was then loaded into the vacuum chamber as shown in Figure 4. The chamber was evacuated to a pressure of 1 x $10^{-6}$ mbar prior to starting the process. At this stage Argon was admitted to attain a pressure of 1 x $10^{-2}$

mbar whereupon a high frequency (300 kHz) bias potential was applied to the wire handling system which was isolated from ground. A bias potential of -200V is achieved prior to transferring the wire 4 from reel 3 to reel 2 such that a residence time of 10 minutes was achieved. On completion of the cleaning cycle the pressure is reduced to $7 \times 10^{-3}$ mbar and the deposition process started.

4 kW of DC power was supplied to the aluminium target 5 which stabilises to a voltage of -480 volts. This voltage varied with sample geometries, target material and gas composition, e.g. on introducing oxygen gas to the system the target voltage will drop (in systems where power is the controlled parameter) as the oxygen reacts with the target to "poison" the surface. By careful closed loop monitoring and control of the system e.g. by quadrupole mass spectrometer sensing, the oxygen introduction was held such that just sufficient oxygen was introduced to react with the sputtered aluminium to form Alumina without significantly poisoning the target. The oxygen level was held in balance such that the alumina deposited is as cose to full stoichiometry as possible. The wire passes from reel 2 to reel 3 being reactively coated as it passed the target 5. Residence time in this region was controlled by wire speed and adjusted to give the required thickness. The roller mechanism alternated the wire face exposed to the target as it progresses down the target length. Target 6 was not employed.

The coated conductors were then provided with a 0.25 mm insulating layer of low density polyethylene which was crosslinked by irradiation with high energy electrons to a dose of 20 Mrads.

The electrical performance of the insulated wires so formed was tested by twisting a pair of identical wires (2 twists per 2.5 cms length) to form a twisted pair cable of 1.5 m in length, connecting one end of the wires to a 1 MHz, 30V square wave source and observing the wave across a 200 ohm load at the other end of the wires by means of an oscilloscope. The central section of the wires (about 0.5m in length) was placed in an electric tube furnace and heated at a rate of 20°C per minute. The temperature of the wires when the insulation fails was recorded. The wires were then allowed to cool and the insulation of the wire retested. It was noted that the polymeric insulation layer auto ignites at approximately 430°C, leaving only the thin oxide layer as insulation, which continued to function perfectly until the failure temperature indicated.

By way of comparison, the procedure was repeated, using wires insulated only by the crosslinked polyethylene.

The results are shown in Table I, from which it may be seen that wires prepared according to the invention are superior to polymeric insulation both in regard to the temperature at which insulation is lost and by virtue of the reversibility of the loss on subsequent cooling.

## TABLE I

|  | Temperature of total insulation failure | Performance after cooling |
|---|---|---|
| EXAMPLE 1 | 500°C | insulating |
| EXAMPLE 2 (Comparison) | 430°C | conducting |

EXAMPLES 3 and 4

Examples 1 and 2 were repeated, with the exception that the twisted pair cables were subjected to heating in a propane gas burner having a flat flame 8 cm wide. The temperature of the flame just below the twisted pairs was maintained at 620°C and the time to failure recorded.

The results are given in Table II, from which it may be seen tht wires according to the invention exhibit greater times to failure. The polymeric insulation burns away in the propane flame quickly, leaving the oxide layer as sole insulation until ultimate failure.

## TABLE II

Time to failure in 620°C
propane flame

| EXAMPLE 5 | 2 minutes |
| EXAMPLE 4 (Comparison) | 20 seconds |

### EXAMPLES 5 to 7

In Example 5, Example 1 was repeated except that target 6 (figure 4) was employed to deposit a layer of aluminium metal onto the copper prior to the deposition of the aluminium oxide layer. Oxygen was supplied locally (and monitored locally) to target 5 to prevent contamination of target 6 which was shielded within the chamber . In Example 6 and 7 Example 5 was repeated with the exception that an oxygen gradient was estab lished on target 5 to form an oxide layer intermediate between the metal interlayer (from target 6) and the oxide layer from the bottom of target 5. Oxide thickness can be increased by reversing the wire back past target 5 as required. Target 6 is not employed in these subsequent passes. Twisted pair cables were tested in the tube furnace and in the propane gas burner as described in Examples 1 to 4.

In all the examples the top layers of uniform stoichiometry aluminium oxide had a thickness of approximately 2 micrometres. The results are given in Table III from which it may be seen that the presence of one or more interlayers significantly increases the temperature of time to insulation failure. As noted from Example I, the polymeric portion of the insulation auto ignited in the tube furnace at approximately 430°C, leaving the thin composite oxide layers to function as sole insulation until the indicated temperature of failure. Similarly, the polymeric portion quickly burned away in the propane flame.

### TABLE III

| Example No. | Aluminium layer micrometres | Aluminium oxide intermediate layer, micrometres | Temperature total insulation failure (furnace test) | Time to failure in 620°C deg. flame |
|---|---|---|---|---|
| 1 | 0 | 0 | 500°C | - |
| 3 | 0 | 0 | - | 2 minutes |
| 5 | 0.2 | 0 | 750°C | not measured |
| 6 | 0.3 | 0.3 | 800°C | >30 mins |
| 7 | 0.3 | 0.3 | >750°C | >30 mins* |

* flame temperature was 650°C for this experiment.

Note: In Table III the inequality sign > signifies that the test was terminated at the time indicated, no failure of the insulation being recorded.

Example 7 was the same as Example 6, except that 7 strand 20 AWG wire was used. This Example shows clearly that excellent high temperature insulation may be obtained even when only a portion of each outer strand is covered with the thin composite layer.

EXAMPLES 8 to 14

Copper conductors were provided with insulating oxide layers under the following conditions: Example 8 as Example 1. Examples 9 to 11 as Example 5. Examples 12 to 14 as Example 6. The necessary adjustments to wire speed/ wraps and hence residence time was adjusted to achieve the correct thickness of the various layers.

The DC electrical resistivity of the oxide layers was measured before and after heating the coated conductor to 900°C for 30 seconds using a bunsen burner in place of the propane burner of Examples 3 and 4. The oxide film was observed after the heat exposure for adherence, cracks, etc. The results are given in Table IV, from which it may be seen that by the use of interlayers (i.e. aluminium and varying stoichiometres of aluminium oxide) adhesion can be improved to the point where no spalling occurs, even at 900°C and also films which are highly resistive before and after exposure to this temperature can be obtained.

TABLE IV

| EXAMPLE | ALUMINIUM LAYER, MICROMETRES | ALUMINIUM OXIDE INTERMEDIATE LAYER, MICROMETRES | ALUMINIUM OXIDE, TOP LAYER, MICROMETRES | RESISTIVITY BEFORE EXPOSURE OHM. CM. | RESISTIVITY AFTER EXPOSURE TO 900°C 10 SECS. | OBSERVATIONS |
|---|---|---|---|---|---|---|
| 8 | 0 | 0 | 2.0 | $7 \times 10^{10}$ | fail (1) | Severe spalling, severe copper migration through layer. |
| 9 | 0.1 | 0 | 2.0 | $9 \times 10^{9}$ | fail (1) | slight spalling severe copper migration through layer |
| 10 | 0.6 | 0 | 1.9 | $2 \times 10^{11}$ | fail (1) | localised spalling |
| 11 | 1.0 | 0 | 2.0 | $3 \times 10^{10}$ | fail | – do – |
| 12 | 0.3 | 0.3 | 2.0 | $6 \times 10^{11}$ | $1 \times 10^{11}$ | some cracking but remains intact |
| 13 | 0.3 | 0.3 | 2.2 | $9 \times 10^{10}$ | $6 \times 10^{11}$ | – do – |
| 14 | 0.6 | 0.6 | 2.4 | $5 \times 10^{10}$ | $1 \times 10^{11}$ | – do |

NOTE:   (1) Fail = does not support 30V

## EXAMPLE 15

7 Strand 20 AWG copper conductors were provided with a composite coating consisting of a first layer of 2 micrometres of titanium, a second layer of 2 micrometres of graded stoichiometry $TiO_x$ in which $x$ varied from 0 to 2, and a third layer of 2 micrometres of $TiO_2$ prepared as Example 7 with the exception that the targets 5, 6 were replaced with Titanium metal targets. The necessary adjustments to residence times were made for thickness control. Twisted pairs of these coated conductors were heated to 900°C for 10 seconds. It was observed that coating remained intact, with no spalling and no copper migration through the layer.

## EXAMPLE 16

A cable formed as described above with reference to figure 2 was tested for its integrity by placing a length of it in a flame at 800°C and recording the length of time before a short circuit was formed between any two stranded conductors or between any stranded conductor and the shield 4 (IEC 331 test). No failure was recorded after 90 minutes.

## EXAMPLE 17

Copper conductors were provided with a composite coating consisting of a first layer tantalum, a top layer of tantalum oxide and an intermediate layer which varies in stoichiometry from metal to $Ta_2 O_5$. Preparation is as Example 7. The metal interlayer measured 1.1 micrometres, combined intermediate and topcoats measured 2.3 micrometers.

D.C. electrical resistivity was measured as $2.5 \times 10^{13}$ ohm cm prior to exposing the sample to a bunsen flame of 900°C for 30 seconds. D.C. resistivity upon cooling was measured as $1.3 \times 10^{12}$ ohm cm. The samples were also examined using a scanning electron microscope. No spalling or copper migration was noted.

The volume resistivity was also measured at elevated temperature in an apparatus which consists of a block of steel, heated by cartridge heaters, which formed one electrode of the measuring circuit, and a probe of known contact area which formed the other electrode. The components were housed in an earthed Faraday cage. The heating rate of the block was not uniform: it heated at approximately 25°C/min up to about 400°C, decreasing steadily to about 10°C thereafter. The limit of the apparatus was about 650°C. The volume resistivity was measured using a megohm meter made by Avo Ltd., of Dover, England, at a test voltage of 30V D.C.

Using this apparatus, the volume resistivity was measured at frequent temperature intervals so that it was possible to measure the temperature at which the conductor insulation will no longer support 30V, the curve being almost flat until this temperature. For the tantalum oxide coated conductors of Example 15, this fail temperature is 485°C.

## EXAMPLE 18

Solid conductor was provided with a composite refractory coating as described in Example 6. An additional coating TIN measuring 2 micrometers thick was subsequently sputtered onto the surface by the reactive process used in example 6, with the exception that the aluminium target 5 is replaced with a titanium target 5. The reactive gas employed is nitrogen for this latter coat.

The scrape abrasion resistance of the coatings was compared with that of example 6 using the following apparatus: a loaded blade was drawn repeatedly back and forth across the surface of the coated conductors at a frequency of 1Hz, gradually wearing away the coatings as it did so. The blade was made of hardened steel, and had a radius of curvature of 0.225mm; its stroke was 2.5. cm. The load used was 5N.

Abraded samples were examined using an optical microscope, and failure was considered to have failed when the copper conductor became esposed. Example 6 failed after 23 blade cycles on average. Example 18 failed after 110 blade cycles on average. This improvement demonstrates that specific properties of coated conductors can be improved by the addition of extra protective layers.


EXAMPLE 19

Solid 20 AWG copper conductors were provided with a composite coating consisting of a first layer of 0.4 microns of titanium, a second layer of 0.4 mcron graded stoichiometry $TiO_x$ and a third layer of 2 microns of $TiO_2$ prepared as in Example 15 with the necessary adjustments to residence time to control thickness. The conductors were heated in a bunsen flame to 900°C for 30 seconds : the film coating remained intact, with no spalling and no copper migration through the coating.


EXAMPLES 20 to 22

Copper conductors were provided with an insulating layer of aluminium oxide of varying thickness by RF sputtering from an alumina target using the following conditions. Preparation was followed as in Example 1 up to the start of the deposition process. At that stage Alumina was sputtered from an alumina target 5 onto the wire 4 as it passed from reel 2 to reel 3. Sputtering was achieved by raising the cathode assembly 5 - Magnetron plus target - to a potential with respect to ground of -370 volts by application of 2.5 KW of power from a radio frequency generator. On striking a plasma the impedance was matched to reduce reflected power to less than 3%. Wire speed was adjusted to give the required thickness. Target 6 was not employed.

The temperature controlled volume resistivity rig described in Example 17 was used to determine the relationship between alumina thickness and fail temperure.

The results are given in Table V.

## TABLE V

| EXAMPLE | ALUMINA THICKNESS | FAILURE TEMPERATURE |
|---|---|---|
| 20 | 0.7 microns | 375°C |
| 21 | 1.3 microns | 410°C |
| 22 | 15 microns | >650°C* |

*Temperature limit of equipment.

These Examples clearly demonstrate that the performance of the coated conductors can be altered at will by choice of the thickness of the insulation. It should be noted that the insulated conductors of Example 22 do not fail up to the limits of the test equipment and even at 650°C the volume resistivity of $>10^8$ ohm cms.


EXAMPLE 23

Copper conductors were provided with an insulating layer of silica, of thickness 16 microns, by RF sputtering from a silica target using the same procedure as used for examples 20 to 22 with the exception that the alumina target 5 is replaced by a silica target 5.

The volume resisitivity fail temperature was measured as in Example 17 and is found to be greater than 650°C, the volume resisitivity at this temperature still being $10^8$ ohm cms.

EXAMPLES 24 to 27

7 strand 20 AWG copper conductors were provided with a composite coating consisting of a first layer of aluminium, a second layer of graded stoichiometry $Al_2O_x$ and a third layer of alumina prepared as in Example 7.

Twisted pairs of identical wires (2 twists per 2.5 cm length) were tested for signal integrity with a 1MHZ 30V square wave source, as described in Example 1, in a bunsen flame at 500°C and at 700°C. The results are given in Table VI.

TABLE VI

| EXAMPLE | ALUMINIUM LAYER | ALUMINIUM OXIDE INTERMEDIATE | ALUMINIUM OXIDE TOP LAYER, MICRONS | TIME/TEMP TO FAILURE IN BUNSEN FLAME |
|---|---|---|---|---|
| 24 | 0.4 | 0.4 | 0.65 | 23 mins/500°C |
| 25 | 0.4 | 0.4 | 0.65 | 2 mins/700°C |
| 26 | 0.4 | 0.4 | 1.9 | no failure after 30 mins/ 500°C plus 30 mins/700°C |
| 27 | 0.4 | 0.4 | 1.9 | 75 mins/700°C |

By way of comparison, the procedure was repeated using wires insulated only by crosslinked polyethylene: a failure time of 20 seconds at 500°C was measured.

These results clearly demonstrate that even very thin composite coatings made according to the invention survive for significant periods of time at 500°C. They also show that slightly thicker films (1.9 microns) can function for extended periods of time at significantly higher temperatures.

EXAMPLES 28 and 29

Copper conductors were provided with an insulating alumina layer by Rf sputtering from an alumina target using the conditions described in Examples 20 to 22. They were then tested for signal integrity in a bunsen flame using the method described in Example 1, and the results are given in Table VII.

## TABLE VII

| Example | Alumina thickness microns | Time/temp to failure in bunsen flame |
|---------|---------------------------|--------------------------------------|
| 28 | 2.9 | 10 mins/700°C * |
| 29 | 15 | 115 mins/850°C * |
| 30 | 15 | 150 mins/700°C ** |

\* failed due to copper migration

\*\* test terminated without sample failure

These results clearly show the insulating qualities obtainable by coating conductors according to this invention. They also show the very significant increase in lifetime at elevated temperatures which may be obtained by use of a thicker film. Thus one is able to make a simple choice of insulation thickness for different operating environments.

By comparing Examples 27 and 28, it is possible to see the effect of the intermediate layer on insulation performance: from Example 28, one would expect that a short failure time (i.e. less than 10 mins at 700°C) would be obtained using an alumina thickness of 1.9 microns. However, as already seen in Example 27, the composite coating which is thinner in total thickness as well as in the insulating portion, clearly and significantly out performs the coated conductor of Example 28. From examination of the failure specimens by scanning electron microscopy it is seen that both Example 27 and 28 fail by copper migration but that copper migration is severely hindered by presence of the interlayer.

Thus this comparison illustrates that the intermediate layers provide improved insulating performance undere harsh thermal environment by significantly suppressing the failure mechanism.

EXAMPLE 31

Copper conductors were provided with an insulating silica layer of thickness 16 microns by RF sputtering from a silica target under the conditions described in Example 23.

They were then tested for signal integrity as described in Example 29 : failure was obtained only after exposure for 90 mins.

EXAMPLE 32-34

Copper conductors were provided with a 5 micrometer insulating alumina layer bound to the copper by an interlayer of pure metal 0.5 micrometres thick. The metal was either Aluminium in one case or titanium in another case. The aluminium interlayer case was demonstrated on both solid and stranded wire conductor. Deposition was as described in Example 5 with the exception that the insulating alumina layer is Rf sputtered as described in Examples 20 to 22. Target 6 was replaced by titanium in the case of the titanium interlayer.

The wires were subjected to signal integrity testing as in Example 28. The failure times are recorded in table VIII.

## TABLE VIII

| EXAMPLE | WIRE TYPE | INTERLAYER | FAILURE TIME |
|---|---|---|---|
| 32 | 7 Strand 20 AWG | Aluminium | 61 minutes |
| 33 | Solid 20 AWG | Aluminium | 36 minutes |
| 34 | Solid 20 AWG | Titanium | 26 minutes |

The failure times when compared with Example 28 clearly illustrate the benefits of an interlayer for high temperature performance, even when an intermediate layer of varying stoichiometry as in Example 27 is absent. The data also demonstrates that the improvement is achieved even when using metal interlayers which differ from that of the metal oxide.

EXAMPLES 35 to 39

Examples 35 to 39 examine the onset temperature for the failure mechanism described as "copper migration" or "conductor migration". The examples use specimens described in earlier examples.

i.e. Example 35 prepared as Example 6

Example 36 prepared as Example 14

Example 37 prepared as Example 21

Example 38 prepared as Example 28

Example 39 prepared as Example 22

The test involved exposing specimens to high temperatures for short (1 minute) periods of time. A high temperature tube furnace was controlled to within a set temperature ±1% with a sample pan situated in the centre of the oven. The pan was preheated to the set temperature prior to being pneumatically extracted for automatic sample loading and return to the oven. The sample pan temperature was accurately monitored and any temperature drop noted during loading was recovered within the 1 minute period. Loading time was 53 seconds.

Specimens of each example was exposed to a range of temperatures for the specified period and subsequently examined using a scanning electron microscope for the effect described as "conductor migration". The temperature at which the effect was first noted was recorded as the onset temperature.

| Example | Aluminium layer microns | Aluminium intermediate layer microns | Aluminium oxide top layer microns | Migration onset temperature |
|---|---|---|---|---|
| 35 | 0.3 | 0.3 | 2 | 750°C |
| 36 | 0.6 | 0.6 | 2.4 | 850°C |
| 37 | 0 | 0 | 1.3 | <550°C |
| 38 | 0 | 0 | 2.9 | 650°C |
| 39 | 0 | 0 | 15 | >850°C |

The Examples 35 to 39 illustrate 4 points. Firstly the surprisingly low temperatures at which "conductor migration" occurs is demonstrated by Example 37 in which the effect is seen at a temperature approximately half that of the melting temperature of the conductor. Secondly, the benefit of increased top coat thickness is demonstrated by Examples 37 to 39. Thirdly the benefits of an interlayer are seen by comparing Examples 35 and 36 with Example 38. By simply comparing topcoat thicknesses one would expect the Examples 35 and 36 to display onset temperatures lower than that for Example 38. In fact the opposite is shown thus demonstrating the effect of the interlayers. Fourthly, the benefits of increasing interlayer thickness are demonstrated by comparing Example 35 to Example 36.

## EXAMPLE 40

19 strand 20 AWG copper wires were provided with an insulating alumina coating 3 micrometres thick around their outer circumference by techniques described in Examples 20 to 22. On subjecting Example 40 to signal integrity testing as described in Example 3, except using a 700°C flame, the time to circuit failure was recorded as 12 minutes. Wire insulated with only 0.2mm of crosslinked polyethylene failed after 15 seconds under the same conditions. This Example clearly shows that excellent high temperature insulation is obtained even when only a portion of each outer strand is covered with the thin refractory coating. Examples 40 differs from previous multistrand wire Examples in that the number of strands is increased to 19, thereby further reducing the portion of outer strand covered by the thin refractory coating.

## EXAMPLE 41

7 strand 20 AWG copper wires were provided with a 1 micrometre coating of aluminium by sputtering as previously described for depositing the interlayer in Example 5. The wire was then subjected to a heat treatment by passing slowly through a tube furnace a 500°C such that the residence time of 7 minutes is achieved. A highly adherent gold coloured copper/aluminium intermetallic layer is confirmed as having being formed by X-ray crystallography. The intermetallic covered wire is provided with a 5 micrometres thick coating of alumina by techniques described in Examples 20 to 22. Signal integrity testing as described in Example 40 results in signal failure after 46 minutes. This Example clearly illustrates the benefits obtained by the presence of intermetallic layers intermediate to the conductor and insulation.

## EXAMPLE 42

19 strand 20 AWG wires were provided with an insulating alumina coating 5 micrometres thick as described in Example 40. This Example differs from Example 40 by the presence of a conventionally applied tin coating as used frequently in the Wire and Cable Industry and the fact that the test temperature was 800°C. On subjecting the wires to signal integrity testing as described in Example 40 the following failure times were recorded.

Example 42 : Tin Coated: 166 minutes

It is believed that the exceptionally long survival time is due to the formation of a tin/copper intermetallic layer.

## Claims

1. A metallic conductor which comprises a bundle of metallic strands the bundle having an adherent electrically insulating refractory coating which extends around the circumference of the bundle but not around the individual strands.

2. A conductor as claimed in claim 1, wherein the adherent refractory coating comprises an oxide or nitride of a metal or semi-metal.

3. A conductor as claimed in claim 2, wherein the refractory coating comprises an oxide of aluminium, silicon, titanium or tantalum.

4. A conductor as claimed in any one of claims 1 to 3, wherein the refractory coating is bonded to the conductor by a metallic or refractory intermediate layer.

5. A conductor as claimed in claim 4, wherein the intermediate layer comprises the metal from which the refractory coating is formed.

6. A conductor as claimed in any one of claims 1 to 5, wherein the refractory coating contains the metal or semi-metal in a stoichiometric excess.

7. A conductor as claimed in any one of claims 1 to 6, wherein the refractory coating has been formed by a vacuum deposition method.

8. A conductor as claimed in claim 7, wherein the refractory coating has been formed by a sputter ion plating method.

9. A conductor as claimed in any one of claims 1 to 8, wherein one or more additional layers are deposited on top of the refractory coating.

10. A conductor as claimed in any one of claims 1 to 9, which has a melting point of at least 800°C.

11. A conductor as claimed in any one of claims 23 to 42, wherein the refractory coating has a thickness in the range of from 0.5 to 15 micrometres preferably from 2 to 7 micrometres.

12. An electrical wire which comprises a conductor as claimed in any one of claims 1 to 11 and, surrounding the conductor, a layer of polymeric insulation.

Fig. 1.

Fig. 2.

# *Fig.3.*

# *Fig.4.*

VACUUM
PUMP

ELEMENTAL DEPTH PROFILE OF
THIN FILM

Fig.5.

AI (METAL)
AI (IN OXIDE)
O
Cu

0 249 252

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | CH-A- 587 548 (BATTELLE) <br><br> * Whole document * | 1-5,7, 11,12 | H 01 B 3/10 <br> H 01 B 7/34 |
| | --- | | |
| X | GB-A-1 133 333 (WILKINSON SWORD) <br> * Whole document * | 1-3,7, 10 | |
| | --- | | |
| X | US-A-3 455 021 (E.H. OLSON) <br><br> * Whole document * | 1-5,7, 11,12 | |
| | --- | | |
| A | FR-A- 559 465 (J. JARRIANT) <br> * Whole document * | 1 | |
| | ----- | | |

TECHNICAL FIELDS SEARCHED (Int. Cl.4)

H 01 B 3/00
H 01 B 7/00
H 01 B 13/00

The present search report has been drawn up for all claims

| Place of search | Date of completion of the search | Examiner |
|---|---|---|
| THE HAGUE | 22-09-1987 | DROUOT M.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document. but published on. or after the filing date
D : document cited in the application
L : document cited for other reasons

& : member of the same patent family, corresponding document

EPO Form 1503 03 82